(19) Europäisches Patentamt / European Patent Office / Office européen des brevets

(11) **EP 1 482 575 B1**

(12) # EUROPÄISCHE PATENTSCHRIFT

(45) Veröffentlichungstag und Bekanntmachung des Hinweises auf die Patenterteilung:
**09.11.2011 Patentblatt 2011/45**

(51) Int Cl.:
***H01L 51/30*** *(2006.01)* ***H01L 51/40*** *(2006.01)*
***C08G 61/12*** *(2006.01)*

(21) Anmeldenummer: **04011625.3**

(22) Anmeldetag: **15.05.2004**

(54) **Stabile Lösungen von organischen halbleitenden Verbindungen**
Stable solutions of organic semiconductor materials
Solutions stables de matériaux organique semiconducteur

(84) Benannte Vertragsstaaten:
**AT BE BG CH CY CZ DE DK EE ES FI FR GB GR HU IE IT LI LU MC NL PL PT RO SE SI SK TR**

(30) Priorität: **28.05.2003 DE 10324533**

(43) Veröffentlichungstag der Anmeldung:
**01.12.2004 Patentblatt 2004/49**

(73) Patentinhaber: **Heraeus Clevios GmbH**
**63450 Hanau (DE)**


(72) Erfinder:

- **Kirchmeyer, Stephan, Dr.**
  **51375 Leverkusen (DE)**
- **Ponomarenko, Sergei Anatolievich, Dr.**
  **Moskau 107589 (RU)**

(74) Vertreter: **Herzog, Martin et al**
**Herzog Fiesser & Partner**
**Patentanwälte**
**Immermannstrasse 40**
**40210 Düsseldorf (DE)**



(56) Entgegenhaltungen:
**WO-A-02/067273 WO-A-03/087222**

- **JENEKHE S A: "SYNTHESIS AND CHARACTERIZATION OF CARBON ATOM BRIDGED HETEROCYCLIC POLYMERS OF SPECIFIED CONJUGATION LENGTH. \1. NOVEL POLYTERTHIOPHENES", MACROMOLECULES, AMERICAN CHEMICAL SOCIETY, US LNKD- DOI: 10.1021/MA00213A005, vol. 23, no. 11, 28 May 1990 (1990-05-28), pages 2848-2854, XP000175130, ISSN: 0024-9297**
- **MENG H ET AL: "OLIGOFLUORENE-THIOPHENE DERIVATIVES AS HIGH-PERFORMANCE SEMICONDUCTORS FOR ORGANIC THIN FILM TRANSISTORS", CHEMISTRY OF MATERIALS, AMERICAN CHEMICAL SOCIETY, WASHINGTON, US LNKD- DOI: 10.1021/CM020866Z, vol. 15, no. 9, 1 May 2003 (2003-05-01), pages 1778-1787, XP008037046, ISSN: 0897-4756**
- **KATZ H E ET AL: "SYNTHESIS, SOLUBILITY, AND FIELD-EFFECT MOBILITY OF ELONGATED AND OXA-SUBSTITUTED ALPHA,ONIEGA-DIALKYL THIOPHENE OLIGOMERS. EXTENSIONOF POLAR INTERMEDIATE SYNTHETIC STRATEGY AND SOLUTION DEPOSITION ON TRANSISTOR SUBSTRATES", CHEMISTRY OF MATERIALS, AMERICAN CHEMICAL SOCIETY, WASHINGTON, US LNKD- DOI: 10.1021/CM970628H, vol. 10, 1 January 1998 (1998-01-01), pages 633-638, XP000915385, ISSN: 0897-4756**
- **LAQUINDANUM J G ET AL: "SYNTHESIS, MORPHOLOGY AND FIELD-EFFECT MOBILITY OF ANTHRADITHIOPHENES", JOURNAL OF THE AMERICAN CHEMICAL SOCIETY, AMERICAN CHEMICAL SOCIETY, NEW YORK, US LNKD- DOI:10.1021/JA9728381, vol. 120, 16 January 1998 (1998-01-16), pages 664-672, XP001152952, ISSN: 0002-7863**
- **GARNIER F ET AL: "AN ALL-ORGANIC SOFT THIN FILM TRANSISTOR WITH VERY HIGH CARRIER MOBILITY", ADVANCED MATERIALS, WILEY VCH VERLAG, DE LNKD- DOI: 10.1002/ADMA.19900021207, vol. 2, no. 12, 1 December 1990 (1990-12-01), pages 592-594, XP000576217, ISSN: 0935-9648**



Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).


EP 1 482 575 B1

Printed by Jouve, 75001 PARIS (FR)

## Beschreibung

Die Erfindung betrifft stabile Lösungen von organischen halbleitenden Verbindungen sowie deren Verwendung für die Herstellung von stabilen halbleitenden Schichten für die Halbleitertechnik.

Werden halbleitende Verbindungen aus Lösung aufgebracht, so sinken die Mobilitäten der Ladungsträger meist stark ab. In der Regel wird das Absinken der halbleitenden Eigenschaften bei Prozessierung von halbleitenden Verbindungen aus Lösung auf die mäßige Löslichkeit und geringe Tendenz zur Filmbildung, letztgenanntes insbesondere bei oligomeren Verbindungen zurückgeführt. So werden Inhomogenitäten beispielsweise auf Ausfällungen während der Trocknung aus der Lösung zurückgeführt (Chem. Mater., 1998, Band 10, S. 633).

Für die Verarbeitung aus flüssiger Phase wurden in der Literatur verschiedene Lösungsmittel vorgeschlagen. In der Regel werden Lösungsmittel bevorzugt, die eine relative hohe Lösekraft für organische halbleitende Verbindungen, im Folgenden auch als organische Halbleiter bezeichnet, aufweisen. Als geeignete Lösemittel sind beispielsweise Chloroform, Toluol, THF, p-Xylol, Chlorbenzol und 1,2,4-Trichlorbenzol beschrieben (Appl. Phys. Lett., 1996, B. 69, No. 26, S. 4108; J. Mater. Chem., 1999, B. 9, S. 1895, Synth. Met., 1999, B. 102, S. 897).

Lösungen von Halbleitern unterliegen allerdings einer Alterung, welche die Qualität der gelösten Halbleiter und damit ebenfalls die Qualität der aus den Halbleiter erzeugten Schichten negativ beeinflusst. Diese Alterung führt zur chemischen Veränderung der Lösungen und Ausfällungen, so dass diese Lösungen hierdurch unbrauchbar werden. Häufig sind diese Veränderungen in den Anfängen ohne aufwändige Messungen nicht bestimmbar, so dass die Gefahr besteht, nachteilig veränderte Lösungen zu verarbeiten und dadurch zu unbrauchbaren Schichten und unbrauchbaren Transistor-Aufbauten zu gelangen. Es ist daher notwendig, die Lösungen umgehend nach deren Herstellung zu verarbeiten. Dennoch kann nicht ausgeschlossen werden, dass sich Lösungen von Halbleitern selbst in kurzer Zeit nachteilig verändert werden.

Veränderungen an Lösungen von organischen Halbleitern können z.B. durch optische Methoden, beispielsweise durch Aufnahme eines UV/Vis-Spektrums festgestellt werden.

Zur Stabilisierung von Lösungen halbleitender Oligomere wie 5,5"-diphenyl-2,2'-5',2"ter(3,4-ethylendioxythiophen) oder leitfähiger Polymere wie tetradecylsubstituiertem Poly(3,4-ethylendioxythiophen), in organischen Lösungsmitteln wurde kürzlich die Zugabe des Reduktionsmittels Hydrazin von F.C. de Schryver et al. (Synthetic Metals 2003, 132, 289-295) beschrieben. Zum Einen ist jedoch die Handhabung von Hydrazin mit erheblichen Gefahren und somit aufwendigen Sicherheitsvorkehrungen verbunden und somit für den großtechnischen Einsatz nachteilig; zum Anderen unterscheiden sich leitfähige von halbleitenden Polymeren deutlich im Redoxverhalten, so dass zu erwarten ist, dass Stabilisatoren für entsprechende Lösungen unterschiedlichen Anforderungen genügen müssen.

Untersuchungen zur Stabilität von Lösungen von Poly(3-alkylthiophenen) in organischen Lösungsmitteln haben gezeigt, dass UV-Vis-Bestrahlung solcher Lösungen in Gegenwart von Sauerstoff zur Kettenspaltung bzw. Reduktion der mittleren $\pi$-Konjugationslänge der Polythiophenketten fuhrt. Dabei zeigte sich, dass die Kettenspaltung und Verkürzung der Konjugationslänge in hohem Maße durch die Anwesenheit von Sauerstoff gefördert wird, was auf die Beteiligung von Singulett-Sauerstoff zurückgeführt wurde. Auch die Verwendung von Lösungsmitteln, die Reaktionen freier Radikale begünstigen, wie beispielsweise Chloroform, führte zu einer deutlich höheren Spaltungsrate als beispielsweise der Einsatz von Benzol (S. Holdcroft, Macromolecules 1991, 24, 4834-4838).

Holdcroft et. al. konnten zeigen, dass durch die Zugabe von Anthracen, welches als Fänger für Singulett-Sauerstoff unter Bildung von Anthrachinon dient, die Kettenspaltung und Verkürzung der Konjugationslänge bei Bestrahlung solcher Poly(3-alkylthiophen)-Lösungen deutlich vermindert jedoch nicht vollständig verhindert werden konnte. Weiterhin wurde zur Stabilisierung die vollständige Entfernung von Sauerstoff aus den entsprechenden Lösungen vorgeschlagen (Macromolecules 1993, 26, 2954-2962).

Eine wichtige Voraussetzung zur Herstellung hochwertiger organischer Halbleiterschaltungen sind Verbindungen und somit auch halbleitende Schichten extrem hoher Reinheit. In Halbleitern spielen Ordnungsphänomene eine große Rolle. Behinderung an einheitlicher Ausrichtung der Verbindungen und Ausprägungen von Korngrenzen führt zu einem dramatischen Abfall der Halbleitereigenschaften, so dass organische Halbleiterschaltungen, die unter Verwendung nicht extrem hochreiner Verbindungen gebaut wurden, in der Regel unbrauchbar sind. Verbleibende Verunreinigungen können beispielweise Ladungen in die halbleitende Verbindung injizieren ("Dotierung") und damit das On/Off-Ratio, d.h. die Kennlinie des Transistors negativ verändern oder als Ladungsfallen dienen und damit die Mobilität der Ladungsträger drastisch herabsetzen. Somit werden durch Verunreinigungen die wichtigsten charakteristischen Eigenschaften eines Feldeffekt-Transistors, nämlich die Mobilität der Ladungsträger, die entscheidend die Schaltgeschwindigkeit des Transistors bestimmen und das Verhältnis zwischen den Strömen im geschalteten und ungeschalteten Zustand, das sogenannte "On/Off ratio", negativ beeinflusst. Eine Zugabe von Verbindungen wie Anthracen zu Lösungen halbleitender Polymerer, würde entsprechende Schichten für die Anwendung in der Halbleitertechnik unbrauchbar machen, da Anthracen sowie Anthrachinon aus den Schichten nicht mehr zu entfernen wären.

Weiterhin ist die vollständige Entfernung von Sauerstoff aus den verwendeten Lösungsmitteln für den großtechnischen Einsatz mit extrem hohen Kosten und entsprechendem Aufwand verbunden und somit nicht sinnvoll.

Es besteht daher weiterhin Bedarf an stabilen Lösungen organischer halbleitender Verbindungen, welche über eine möglichst lange Zeit keinen chemischen Veränderungen unterliegen und folglich lange Verarbeitungszeiten aufweisen und zur Herstellung qualitativ hochwertiger Halbleiterschichten geeignet sind.

Die Aufgabe bestand daher darin, stabile Lösungen organischer halbleitender Verbindungen bereitzustellen, die für die Herstellung hochwertiger Halbleiterschichten geeignet sind.

Es wurde nun gefunden, dass Lösungen von organischen halbleitenden Verbindungen dadurch stabilisiert werden können, indem man ihnen eine basische Verbindung zusetzt.

Gegenstand der vorliegenden Erfindung sind daher Lösungen enthaltend organische halbleitende Verbindungen, dadurch gekennzeichnet, dass sie wenigstens ein Lösungsmittel und als Stabilisator wenigstens eine basische Verbindung enthalten, **dadurch gekennzeichnet, dass** die basische Verbindung ein primäres, sekundäres oder tertiäres Amin, eine basische aromatische oder aliphatische heterocyclische Verbindung oder eine Mischung aus zwei oder mehr dieser Verbindungen
oder
ein Alkali-oder Erdalkalihydroxid, ein Alkali- oder Erdalkalicarbonat, ein Alkali- oder Erdalkalisalz einer schwachen Säure oder eine Mischung aus zwei oder mehreren dieser Verbindungen oder ein basische Gruppen enthaltendes Polymer ist. Unter organischen halbleitenden verbindungen werden im Sinne der Erfindung solche organischen Verbindungen verstanden, die eine elektrische Leitfähigkeit von maximal $10^{-2}$ S/cm, vorzugsweise maximal $10^{-5}$ S/cm und eine Ladungsträgermobilität von mindestens $10^{-5}$ $cm^2/Vs$ aufweisen. Ladungsträgermobilitäten sind dem Fachmann bekannt und können beispielsweise wie in M.Pope and C.E.Swenberg, Electronic Processes in Organic Crystals and Polymers, 2nd ed., S. 709 -713 (Oxford University Press, New York Oxford 1999) beschieben, bestimmt werden.

WO 03/087222 A offenbart die Merkmale des Obergriffs des Anspruchs 1.

Als basische Verbindungen kommen im Rahmen der Erfindung sowohl Brönsted-Basen (Protonenakzeptoren) als auch Lewis-Basen (Elektronenpaar-Donatoren) in Frage, dabei kann es sich sowohl um anorganische als auch um organische Basen handeln.

Die basischen Verbindungen sind vorzugsweise solche, die entweder leicht verdampfbar oder in dem gewählten Lösungsmittel nicht oder nur wenig löslich sind und daher auf einfache Art und Weise von den organischen halbleitenden Verbindungen entfernt werden können.

Unter leicht verdampfbaren basischen Verbindungen ist die basische Verbindung eines primären, sekundären oder tertiären Amin, eine basische aromatische oder aliphatische heterocyclische Verbindung oder eine Mischung aus zwei oder mehr dieser Verbindungen mit einem Siedepunkt von höchstens 260°C oder höchstens 270°C, vorzugsweise 50°C bis 220°C, besonders bevorzugt 80 bis 150°C zu verstehen. Die Temperaturangaben beziehen sich auf die Siedepunkte bei Atmosphärendruck (1 atm bzw. 1,01325 bar).

Solche basischen Verbindungen, die relativ einfach verdampfbar sind, sind beispielsweise primäre, sekundäre oder tertiäre Amine, basische aromatische oder aliphatische heterocyclische Verbindungen oder eine Mischung aus zwei oder mehreren dieser Verbindungen.

Bevorzugte basische Verbindungen sind gegebenenfalls substituierte aromatische oder gegebenenfalls substituierte gesättigte oder ungesättigte aliphatische heterocyclische Verbindungen mit 5 bis 20 Ring-C-Atomen und 1 bis 3 gleichen oder verschiedenen Ringheteroatomen aus der Gruppe Stickstoff, Sauerstoff und Schwefel,
oder Verbindungen der allgemeinen Formel (I),

$$H_xN(R^{1,2,3})_{3-x} \quad (I)$$

worin

| | |
|---|---|
| x | für 0, 1 oder 2 steht, |
| $R^1$, $R^2$, $R^3$ | für einen, zwei oder drei gleiche oder verschiedene Reste $R^1$, $R^2$, $R^3$ steht, |
| $R^1$, $R^2$, $R^3$ | gleich oder verschieden sind und für gegebenenfalls substituierte lineares oder verzweigtes $C_1$-$C_{20}$-Alkyl, $C_1$-$C_{20}$-Cycloalkyl oder $C_5$-$C_{20}$-Aryl stehen. |

Solche basischen Verbindungen sind beispielsweise Mono-, Di- oder Trialkylamine, bevorzugt solche, die in den verwendeten Lösungsmitteln löslich sind. Dies sind beispielsweise n-Alkylamine, wie z.B. Methylamin, Ethylamin, Propylamin, Buthylamin, Pentylamin, Hexylamin, Heptylamin, Octylamin, Nonylamin, Decylamin oder Dodecylamin, Dialkylamine, wie z.B. Diethylamin oder Diisopropylamin, Trialkylamine, wie z.B. Trimetylamin, Dimethylethylamin,

Triethylamin, Tripropylamin, Tributhylamin, Tripentylamin oder Trihexylamin, oder Mischungen aus diesen, wie z.B. eine Mischung aus n- oder tert-Butylamin. Beispielhaft für gegebenenfalls substituierte aromatische oder gegebenenfalls substituierte gesättigte oder ungesättigte aliphatische heterocyclische Verbindungen mit 5 bis 20 Ring-C-Atomen und 1 bis 3 gleichen oder verschiedenen Ringheteroatomen aus der Gruppe Stickstoff, Sauerstoff und Schwefel seien Pyridin, Pyrazol, Pyrazin, Pyridazin, Pyrimidin, Pyrrol und 3-Pyrrolin genannt. Die vorangehenden Aufzählungen dienen jedoch nur der beispielhaften Erläuterung der Erfindung und sind nicht als abschließend zu verstehen.

Als Substituenten für $R^1$, $R^2$ und $R^3$ kommen beispielsweise lineare oder verzweigte $C_1$-$C_{20}$-Alkylreste, $C_5$-$C_{12}$-Cycloalkylreste oder $C_6$-$C_{14}$-Arylreste in Frage.

Die basischen Verbindungen sind in den stabilen Lösungen in einer Konzentration von 0,001 Gew % bis 20 Gew.-%, bevorzugt von 0,01 Gew % bis 5 Gew.-%, besonders bevorzugt von 0,1 Gew.-% bis 2 Gew.-% enthalten.

Basische Verbindungen, die in dem gewählten Lösungsmittel nicht oder nur wenig löslich sind, sind beispielsweise Alkali- oder Erdalkalihydroxide oder - carbonate bzw. Alkalioder Erdalkalisalze schwacher Säuren wie z.B. Ameisensäure, Essigsäure, Propionsäure usw., oder basische Gruppen enthaltende Polymere, wie z.B. Ionenaustauscher-Polymere.

Ionenaustauscher-Polymere können beispielsweise organische Anionenaustauscher wie Polykondensate, z.B. aus Phenol und Formaldehyd, oder Polymerisate, z.B. durch Copolymerisation aus Styrol, Acrylaten oder Methacrylaten und Divinylbenzol erhältlich, die im Anschluss entsprechend funktionalisiert wurden, sein. Es können aber auch andere entsprechend funktionalisierte Makromoleküle, beispielsweise solche natürlichen Ursprungs wie Cellulosen, Dextrane und Aragosen verwendet werden. Als basische Gruppen können solche Anionenaustauscher funktionelle basische Gruppen, wie beispielsweise primäre, sekundäre oder tertiäre Amingruppen bzw. quartäre Ammoniumgruppen, aufweisen. Je nach Art und Kombination der funktionellen Gruppen können die Ionentauscher in ihrer Basizität variieren. Beispielsweise enthalten stark basische Ionenaustauscher gewöhnlich quartäre Ammoniumgruppen, während schwach basische Ionenaustauscher häufig die weniger basischen primären, sekundären und/oder tertiären Amingruppen tragen. Jedoch sind zwischen stark und schwach basischen Ionenaustauschern auch beliebige Mischformen bekannt. Beispiele für basische Gruppen enthaltende Ionenaustauscher sind mit tertiären Aminen funktionalisierte makroporöse Polymerisate aus Stryrol und Divinylbenzol wie sie z.B. unter dem Handelnamen Lewatit® von der Bayer AG, Leverkusen vertrieben werden.

Unter organischen halbleitenden Verbindungen sind im Rahmen der Erfindung organische halbleitende Polymere zu verstehen. Unter Polymeren sind in dem Zusammenhang alle Verbindungen mit mehr als einer Wiederholungseinheit, bevorzugt mit 4 bis 100 000, besonders bevorzugt mit 4 bis 100, ganz besonders bevorzugt mit 4 bis 10 gleichen oder verschiedenen Wiederholungseinheiten zu verstehen. Organische halbleitende Polymere mit bis zu 10 Wiederholungseinheiten sind dem Fachmann auch als organische halbleitende Oligomere bekannt, so dass der Begriff organische halbleitende Polymere organische halbleitende Oligomere mit umfasst. Die organischen halbleitenden Polymere können ein definiertes Molekulargewicht besitzen oder aber eine Molekulargewichtsverteilung aufweisen. In bevorzugten Ausführungsformen der vorliegenden Erfindung sind die organischen halbleitenden Verbindungen halbleitende Oligomere mit einem definierten Molekulargewicht. In anderen bevorzugten Ausführungsformen der vorliegenden Erfindung sind die organischen halbleitenden Verbindungen halbleitende Polymere mit einer Molekulargewichtsverteilung. Die in den erfindungsgemäßen stabilen Lösungen enthaltenen organischen halbleitenden Verbindungen sind im Prinzip solche, die dem Fachmann bekannt sind. Dies sind beispielsweise gegebenenfalls substituierte Polythiophene, Polyphenylene, Polyfluorene, Copolymere aus gegebenenfalls substituierten Phenylen-, Fluoren-, Vinylen-, Thiophen-Einheiten, wie beispielsweise Polyphenylenvinylene, Polyvinylenthienylene, wobei die Copolymere aus zwei oder mehr verschiedenen der vorangehend aufgeführten Einheiten aufgebaut sein können und die verschiedenen Einheiten alternierend, blockartig, statistisch oder in sonstiger Weise im Copolymeren verteilt sein können.

Bevorzugt sind die organischen halbleitenden Verbindungen solche der allgemeinen Formel (II),

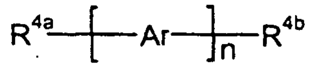

(II)

worin

n für eine ganze Zahl von 4 bis 100 000, bevorzugt 4 bis 100, besonders bevorzugt 4 bis 10 steht,

$R^{4a}$, $R^{4b}$ unabhängig voneinander jeweils für H oder eine gegebenenfalls durch ein(e) oder mehrere O- oder S-Atome, Silylen-, Phosphonoyl- oder Phosphorylgruppen unterbrochene $C_1$-$C_{20}$-Alkylgruppe, bevorzugt unabhängig voneinander jeweils für eine $C_1$-$C_{12}$-Alkylgruppe stehen und

Ar für gegebenenfalls substituiertes 1,4-Phenylen, 2,7-Fluoren oder 2,5-Thiophen steht, wobei Ar gleich oder verschieden sein kann.

Als Substituenten für Ar kommen beispielsweise lineare oder verzweigte $C_1$-$C_{20}$-Alkylreste, bevorzugt $C_1$-$C_{12}$-Alkylreste, $C_1$-$C_{20}$-Alkoxyreste, durch ein oder mehrere O-Atome unterbrochene lineare $C_1$-$C_{20}$-Alkylreste oder $C_1$-$C_6$-Dioxyalkylenreste in Frage. An den 2,7-Fluoreneinheiten sitzen gegebenenfalls vorhandene Substituenten (einer oder mehrere) bevorzugt an der 9-Position.

Besonders bevorzugt sind die organischen halbleitenden Verbindungen solche der allgemeinen Formel (II-a),

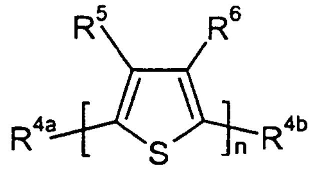

(II-a)

worin

n für eine ganze Zahl von 4 bis 100 000, bevorzugt 4 bis 100, besonders bevorzugt 4 bis 10 steht,

$R^{4a}$, $R^{4b}$ unabhängig voneinander jeweils für H oder eine gegebenenfalls durch ein(e) oder mehrere O- oder S-Atome, Silylen-, Phosphonoyl- oder Phosphorylgruppen unterbrochene $C_1$-$C_{20}$-Alkylgruppe, bevorzugt unabhängig voneinander jeweils für eine $C_1$-$C_{12}$-Alkylgruppe stehen und

$R^5$, $R^6$ unabhängig voneinander jeweils für H oder eine gegebenenfalls substituierte $C_1$-$C_{20}$-Alkylgruppe, eine gegebenenfalls substituierte $C_1$-$C_{20}$-Alkoxygruppe oder gemeinsam für eine gegebenenfalls substituierte $C_1$-$C_6$-Dioxyalkylengruppe, bevorzugt unabhängig voneinander jeweils für H oder eine $C_1$-$C_6$-Alkylgruppe, besonders bevorzugt für H stehen.

Als Substituenten für $R^5$ und $R^6$ kommen beispielsweise lineare oder verzweigte, gegebenenfalls substituierte $C_1$-$C_{20}$-Alkylreste, gegebenenfalls substituierte $C_5$-$C_{12}$-Cycloalkylreste, gegebenenfalls substituierte $C_6$-$C_{14}$-Arylreste in Frage.

Ganz besonders bevorzugte organische halbleitende Verbindungen sind α,α'-Dialkyloligothiophene, wie z.B. α,α'-Dialkylquaterthiophene, α,α'-Dialkylquinquethiophene, oder α,α'-Dialkylsexithiophene, und regioreguläre Poly(3-alkylthiophene).

Die halbleitenden Verbindungen sind in den stabilen Lösungen in einer Konzentration von 0,001 Gew % bis 10 Gew.-%, bevorzugt von 0,01 Gew % bis 5 Gew.-%, besonders bevorzugt von 0,1 Gew.-% bis 1 Gew.-% enthalten. Gegenebenfalls können auch Gemische verschiedener organischer halbleitender Verbindungen verwendet werden.

Die Herstellung der halbleitenden organischen Verbindungen ist dem Fachmann bekannt und kann beispielsweise mittels Kupplung von lithiumorganischen Verbindungen mit Eisen-(III)salzen gemäß J. Am. Chem. Soc. 1993, 115, S. 12214, aus Grignard-Verbindungen (JP-A 02 250 881, EP 1 028 136 A2, J. Chem. Soc., Chem. Commun. 1992, S. 70) oder zinkorganischen Verbindungen (US-A 5,546,889, Synth. Meth. 1993, B. 60, S. 175) in Anwesenheit von Nickelkatalysatoren, mittels oxidativer Kupplung von lithiumorganischen Verbindungen mit Kupfersalzen (Heterocycles 1983,20, S. 1937 oder noch nicht veröffentlichte deutsche Anmeldung DE 10 248 876) erfolgen.

Die erfindungsgemäßen Lösungen organischer halbleitender Verbindungen enthalten darüber hinaus Lösungsmittel, welche die organischen halbleitenden Verbindungen lösen. Erfindungsgemäß ist bevorzugt, jedoch nicht zwingend erforderlich, dass der oder die Stabillsator(en) sich in dem oder den Lösungsmitteln ganz oder teilweise lösen bzw. - für den Fall, dass es sich um flüssige Stabilisatoren handelt - mit dem oder den Lösungsmitteln vollständig oder teilweise mischbar sind.

Als Lösungsmittel kommen im Prinzip alle Lösungsmittel oder Lösungsmittelgemische in Frage, welche die organischen halbleitenden Verbindungen lösen. Ausreichende Löslichkeit ist bereits dann gegeben, wenn mindestens 100 ppm der organischen halbleitenden Verbindungen in dem gewählten Lösungsmittel gelöst sind. Erfindungsgemäß kommen als Lösungsmittel organische Lösungsmittel, insbesondere halogenierte aromatische oder aliphatische Verbindungen, Ether- oder Ketogruppen enthaltende aromatische oder aliphatische Verbindungen oder Mischungen aus zwei oder mehreren dieser Verbindungen in Frage. Bevorzugte Lösungsmittel sind beispielsweise chlorhaltige Verbindungen wie Chloroform, Dichlormethan, 1,2-Dichlorethan, Chlorbenzol und 1,2,4-Trichlorbenzol, aromatische Verbindungen wie Benzol, Toluol oder Xylole, Ethergruppen enthaltende Verbindungen wie Diethylether, tert. Butylmethylether, Dioxan oder Tetrahydrofuran und Ketogruppen enthaltende Verbindungen, wie Aceton oder Methylethylketon oder Mischungen aus zwei oder mehreren dieser Lösungsmittel. Besonders bevorzugte Lösungsmittel sind Chloroform, Chlorbenzol, 1,2,4-Trichlorbenzol oder Toluol, ganz besonders bevorzugt ist Chloroform.

In einer bevorzugten Ausführungsform enthält die erfindungsgemäße Lösung wenigstens ein Lösungsmittel, welches sowohl die halbleitende Verbindung als auch den Stabilisator löst. In einer anderen bevorzugten Ausführungsform ist es jedoch auch möglich, dass der Stabilisator nicht gelöst vorliegt. Ein derartiges Vorgehen kann in solchen Fällen von Vorteil sein, in denen der Stabilisator durch einfache Methoden, beispielsweise durch Dekantieren oder Filtration vor Erzeugung der Schicht entfernt werden kann bzw. soll.

Die erfindungsgemäßen Lösungen von organischen halbleitenden Verbindungen besitzen gegenüber bekannten nicht stabilisierten Lösungen den Vorteil, dass sie stabil sind und sich auch nach längerer Zeit, d.h. bis zu mehreren Tagen, Wochen oder sogar Monaten, sogar in Gegenwart von Sauerstoff nicht verändern. Die erfindungsgemäßen Lösungen sind beispielsweise bei Temperaturen bis 80°C, bevorzugt bis 40°C, besonders bevorzugt bei Raumtemperatur für mehrere Tage, Wochen oder sogar Monate stabil. Beispielsweise konnten erfindungsgemäße Lösungen bei Raumtemperatur (23°C) 14 Tage und länger an Luft, d.h. in Gegenwart von Sauerstoff, gelagert werden, ohne dass signifikante Veränderungen beobachtet wurden.

Überraschend sind sogar erfindungsgemäße Lösungen enthaltend chlorhaltige Lösungsmittel, wie beispielsweise Chloroform, Chlorbenzol, 1,2,4-Trichlorbenzol, bevorzugt Chloroform, in Gegenwart von Sauerstoff stabil, obwohl in Holdcroft et al., Macromolecules 1991, 24, 4834-4838 beschrieben ist, dass gerade diese Lösungsmittel zu einer deutlich höheren Kettenspaltungsrate und somit Zersetzung der dort beschriebenen Lösungen führen. Die vorliegende Erfindung bietet somit die Möglichkeit, stabile Lösungen von organischen, halbleitenden Verbindungen insbesondere auch in chlorierten organischen Lösungsmitteln, insbesondere Chloroform, in Gegenwart von Sauerstoff herzustellen, zu lagern, zu transportieren und zu verarbeiten. Es muss nicht wie in Holdcroft et al. (Macromolecules 1991, 24, 4834-4838 oder Macromolecules 1993, 26, 2954-2962) empfohlen auf solche Lösungsmittel mit hervorragender Lösekraft für organische halbleitende Verbindungen verzichtet oder mit zusätzlichem Aufwand Sauerstoff ausgeschlossen werden. Die Verwendung von Chloroform als Lösungsmittel für halbleitende organische Verbindungen ist besonders vorteilhaft, da beispielsweise Chloroform nicht nur eine hervorragende Lösekraft für halbleitende Verbindungen aufweist, sondern auch in der Regel Schichten, bei deren Herstellung Chloroform als Lösungsmittel verwendet wurde als solche beschrieben werden, welche beispielsweise hohe Ladungsmobilitäten bzw. ein hohes "On/Off ratio" aufweisen (vgl. Appl. Phys. Lett. 1996, B.69, S.4108-4110).

Bei der Herstellung der erfindungsgemäßen Lösungen kann entweder zunächst das organische halbleitende Verbindungen im Lösungsmittel gelöst vorgelegt und dann der Stabilisator zugegeben werden oder es kann umgekehrt eine Lösung, Mischung oder Suspension des Stabilisators hergestellt und dieser dann das organische halbleitende Verbindungen zugegeben werden. Des Weiteren können zuerst organisches halbleitendes Polymer und Stabilisator zusammengegeben und anschließend erst mit Lösungsmittel versetzt werden oder organisches halbleitendes Polymer, Stabilisator und Lösungsmittel können auch gleichzeitig zusammengegeben werden. Die Herstellung kann kontinuierlich oder diskontinuierlich erfolgen.

Aufgrund ihrer Stabilität eignen sich die erfindungsgemäßen Lösungen besonders gut für die Herstellung von Halbleiterschichten in aktiven und lichtemittierenden elektronischen Bauelementen wie Feldeffekt-Transistoren, organischen Lumineszenzdioden, photovoltaischen Zellen, Lasern oder Sensoren.

Weiterhin Gegenstand der vorliegenden Erfindung ist daher die Verwendung der erfindungsgemäßen Lösungen zur Herstellung von halbleitenden Schichten.

Hierzu werden die erfindungsgemäßen Lösungen von organischen halbleitenden Verbindungen in Form von Schichten auf geeignete Substrate, zum Beispiel auf mit elektrischen oder elektronischen Strukturen versehene Silizium-Wafer, Polymerfolien oder Glasscheiben aufgetragen, wobei man das Lösungsmittel anschließend verdampft. Das Aufbringen aus Lösung kann nach den bekannten Verfahren, beispielsweise durch Sprühen, Tauchen, Drucken und Rakeln, Spin-Coating und durch Ink-Jet-Druck erfolgen. Die Entfernung der basischen Verbindung(en) kann vor Auftragen der Lösungen auf die geeigneten Substrate oder zusammen mit dem Lösungsmittel nach Auftragen erfolgen. Für den Fall, dass die basische(n) Verbindung(en) höher als das Lösungsmittel sieden, kann die Entfernung der basischen Verbindung(en) auch nach Entfernen des Lösungsmittels erfolgen. Basische Verbindungen, die im gewählten Lösungsmittel nicht oder nur wenig löslich sind werden bevorzugt vor Auftragung der Lösungen auf die geeigneten Substrate entfernt, basische Verbindungen die leicht verdampfbar sind bevorzugt nach Auftragung der Lösungen auf die Substrate. Sowohl Lösungsmittel als auch leicht verdampfbare basische Verbindung(en) können bei reduziertem Druck oder Atmosphärendruck entfernt werden. Die Entfernung kann beispielsweise bei Raumtemperatur oder erhöhter Temperatur erfolgen. Bevorzugt werden die basischen Verbindungen bei der Herstellung der Schichten nahezu vollständig entfernt, um besonders gute Halbleitereigenschaften der Schichten zu erzielen. Es können aber auch Restmengen basischer Verbindung(en) in den Schichten verbleiben.

Die erfindungsgemäßen Lösungen lassen sich zu qualitativ hochwertigen halbleitenden Schichten verarbeiten.

Diese besitzen vorzugsweise Ladungsmobilitäten von $10^{-3}$ $cm^2/Vs$, besonders bevorzugt von $10^{-2}$ $cm^2/Vs$. Ladungsmobilitäten können beispielsweise wie in M.Pope and C.E.Swenberg, Electronic Processes in Organic Crystals and Polymers, 2nd ed., S. 709 -713 (Oxford University Press, New York Oxford 1999) beschrieben, bestimmt werden.

Weiterhin Gegenstand der vorliegenden Erfindung sind daher Schichten enthaltend Verbindungen der allgemeinen Formel (II),

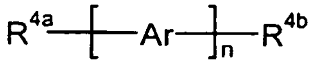

(II)

worin

n, Ar, $R^{4a}$ und $R^{4b}$ die oben genannte Bedeutung haben,

dadurch gekennzeichnet, dass sie aus den erfindungsgemäßen Lösungen hergestellt werden und halbleitend sind.

Bevorzugt sind dies Schichten enthaltend Verbindungen der allgemeinen Formel (II-a),

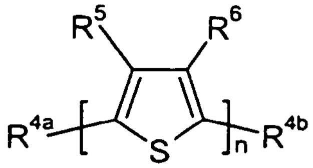

(II-a)

worin

n, $R^{4a}$, $R^{4b}$, $R^5$ und $R^6$ die oben genannte Bedeutung haben.

Die erfindungsgemäßen Schichten eignen sich insbesondere für die Verwendung in aktiven und lichtemittierenden elektronischen Bauelementen wie Feldeffekt-Transistoren, organischen Lumineszenzdioden, photovoltaischen Zellen, Lasern oder Sensoren.

Weiterhin Gegenstand der vorliegenden Erfindung ist daher die Verwendung der erfindungsgemäßen Schichten als Halbleiter in aktiven und lichtemittierenden elektronischen Bauelementen wie Feldeffekt-Transistoren, organischen Lumineszenzdioden, photovoltaischen Zellen, Lasern oder Sensoren.

Die erfindungsgemäßen Schichten können nach dem Aufbringen weiter modifiziert werden, beispielsweise durch eine Temperaturbehandlung, z.B. unter Durchlaufen einer flüssigkristallinen Phase, oder zur Strukturierung z.B. durch Laserablation.

Außerdem ist ein Verfahren zur Herstellung einer halbleitenden Schicht Gegenstand der vorliegenden Erfindung, wobei die Schicht aus einer erfindungsgemäßen Lösung auf ein Substrat aufgebracht wird.

**Beispiele**

**5,5'''-Didecyl-2,2':5',2":5",2'''-quaterthiophen** wurde nach bekanntem Verfahren hergestellt (Chem. Mater. 2003, B. 13, S. 197-202).

Chloroform (Merck, LiChrosolv®), Diisopropylamin (Aldrich, 99.5%) und Triethylamin (Riedel-de Haën 99%) wurden ohne weitere Reinigung eingesetzt.

UV/Vis Messungen wurden mit einem handelüblichen UV/Vis-Spektrometer (Perkin-Elmer Lambda 9) bei Raumtemperatur (23°C) durchgerührt. Messungen wurden von frischen Lösungen, d.h. direkt nach Herstellung, danach in Abständen von 15 Minuten bis zum Ablauf von 2 Stunden ab Herstellung, und anschließend stündlich bis 7 Stunden ab Herstellung sowie täglich nach 1 bis 9 bzw. 1 bis 14 Tagen ab Herstellung durchgeführt.

**Beispiel 1** Untersuchung der Stabilität einer Lösung von 5,5'''-Didecyl-2,2':5',2":5",2'''quaterthiophen in Chloroform.

5,5'''-Didecyl-2,2':5',2":5",2'''-quaterthiophen (2 mg, $3.3 \times 10^{-3}$ mol) wurde in 10 ml Chloroform an Luft gelöst

und sofort UV/Vis-spektroskopisch untersucht (vgl. Fig. 1, Fig. 2). Man kann die folgenden Änderungen während 24 Stunden beobachten (Fig. 1):

1) $\lambda_{max}$ ändert sich von 401 bis 412 nm,

2) die Intensität von $\lambda_{max}$ wird geringer und $\lambda_{max}$ wird breiter,

3) eine neue Absorptionsbande mit Maximum bei ca. 330 nm erscheint.

Während weiterer 9 Tage werden diese Änderungen noch signifikanter (vgl. Fig. 2).

Fig. 1. Änderungen der UV/-Vis Spektra der Lösung von 5,5'''-Didecyl-2,2':5',2":5",2'''-quaterthiophen in Chloroform während 24 Stunden an Luft.

Fig.2. Änderungen der UV/Vis Spektra der Lösung von 5,5'''-Didecyl-2,2':5',2":5",2'''-quaterthiophen in Chloroform während 9 Tagen an Luft.

**Beispiel 2** Untersuchung der Stabilität einer erfindungsgemäßen Lösung von 5,5'''-Didecyl-2,2':5',2":5",2'''-quaterthiophen in Chloroform und Diisopropylamin als Stabilisator.

In 10 ml einer 1 mg/ml Lösung von Diisopropylamin in Chloroform (aus 23 mg des Diisopropylamin und 23 ml Chloroform) wurde 5,5'''-Didecyl-2,2':5',2":5",2'''quaterthiophen (2 mg, $3{,}3\times10^{-3}$ mol) an Luft gelöst und sofort UVNis-spektroskopisch untersucht (Fig. 3). Es wurden keine Änderung der UV/Vis-Spektra während 24 Stunden an Luft beobachtet.

Das Beispiel zeigt, dass die erfindungsgemäße Lösung aus Beispiel 2 mindestens 24 Stunden stabil ist.

Fig.3. UV/Vis Spektra der Lösung von 5,5'''-Didecyl-2,2':5',2":5",2'''quaterthiophen in Chloroform stabilisiert mit Diisopropylamin während 24 Stunden an Luft.

**Beispiel 3** Untersuchung der Stabilität einer erfindungsgemäßen Lösung von 5,5'''didecyl-2,2':5',2":5",2'''-quaterthiophen in Chloroform mit Triethylamin als Stabilisator.

In 10 ml einer 1 mg/ml Lösung von Triethylamin in Chloroform (aus 23 mg Triethylamin und 23 ml Chloroform) wurde 5,5'''-didecyl-2,2':5',2":5",2'''-quaterthiophen (2 mg, $3{,}3\times 10^{-3}$ mol) an Luft gelöst und sofort UV/Vis-spektroskopisch untersucht (Fig. 4). Man sieht keine Änderung in Lage und Intensität von $\lambda_{max}$ während 14 Tagen an Luft.

Das Beispiel zeigt, dass die erfindungsgemäße Lösung aus Beispiel 3 mindestens 14 Tage stabil ist.

Fig.4. UV/Vis Spektra der Lösung von 5,5'''-Didecyl-2,2':5',2":5",2'''-quaterthiophen in Chloroform stabilisiert mit Triethylamin während 14 Tagen an Luft.

Die Beispiele zeigen, dass sich die nicht erfindungsgemäßen Lösungen im Gegensatz zu den erfindungsgemäß stabilisierten Lösungen signifikant verändern.

## Patentansprüche

1. Lösungen enthaltend organische halbleitende Verbindungen, enthaltend wenigstens ein Lösungsmittel und als Stabilisator wenigstens eine basische Verbindung **dadurch gekennzeichnet, dass** die basische Verbindung ein primäres, sekundäres oder tertiäres oder tertiäres Amin, eine basische, aromatische oder aliphatische heterocyclische Verbindung oder eine Mischung aus zwei oder mehreren dieger Verbindungen oder ein Alkali oder Erdalkalihydroxid, ein Alkali oder Erdalkalicarbonat, ein Alkali oder Erdalkalisalz einer schwachen Säure oder eine Mischung aus zwei oder mehreren dieser Verbindungen oder ein basische Gruppen enthaltendes Polymer ist.

2. Lösungen gemäß Anspruch 1, **dadurch gekennzeichnet, dass** die basische Verbindung ein primäres, sekundäres oder tertiäres Amin, eine basische, aromatische oder aliphatische heterocyclische Verbindung oder eine Mischung aus zwei oder mehreren dieser Verbindungen ist und einen Siedepunkt von höchstens 260°C besitzt.

3. Lösungen gemäß Anspruch 1 order 2, **dadurch gekennzeichnet, dass** die basische Verbindung eine gegebenenfalls substituierte aromatische oder eine gegebenenfalls substituierte gesättigte oder ungesättigte aliphatische, heterocyclische Verbindung mit 5 bis 20 Ring-C-Atomen und 1 bis 3 gleichen oder verschiedenen Ringheteroatomen aus der Gruppe Stickstoff, Sauerstoff und Schwefel ist,
oder eine Verbindung der allgemeinen Formyl (I) ist,

$$H_xN(R^{1,2,3})_{3-x} \qquad (I)$$

worin

x für 0, 1 oder 2 steht,
$R^{1,2.3}$ für einen, zwei oder drei gleiche oder verschiedene Reste $R^1$, $R^3$ steht,
$R^1$, $R^2$, $R^3$ gleich oder verschieden sind und für gegebenenfalls substituierte lineares oder verzweigtes $C_1$-$C_{20}$-Alkyl, $C_1$-$C_{20}$-Cycloalkyl oder $C_1$-$C_{20}$-Aryl stehen.

4. Lösungen gemäß wenigstens einem der Ansprüche 1 bis 3, **dadurch gekennzeichnet, dass** die organischen halbleitenden Verbindungen Verbindungen der allgemeinen Formel (II) sind,

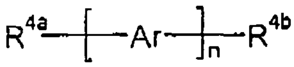

(II)

worin

n für eine ganze Zahl von 4 bis 100 000 steht,
$R^{4a}$, $R^{4b}$ unabhängig voneinander jeweils für H oder eine gegebenenfalls durch ein(e) oder mehrere O- oder S-Atome, Silylen-, Phosphonoyl- oder Phosphorylgruppen unterbrochene $C_1$-$C_{20}$-Alkylgruppe stehen und
Ar für gegebenenfalls substituiertes 1,4-Phenylen, 2,7-Fluoren oder 2,5-Thiophen steht, wobei Ar gleich oder verschieden sein kann.

5. Lösungen gemäß wenigstens einem der Ansprüche 1 bis 4, **dadurch gekennzeichnet, dass** die organischen halbleitenden Verbindungen Verbindungen der allgemeinen Formel (II-a) sind,

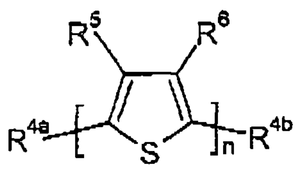

(II-a)

worin

n für eine ganze Zahl von 4 bis 100 000 steht,
$R^{4a}$, $R^{4b}$ unabhängig voneinander jeweils für H oder eine gegebenenfalls durch ein(e) oder mehrere O- oder S-Atome, Silylen-, Phosphonoyl- oder Phosphorylgruppen unterbrochene $C_1$-$C_{20}$-Alkylgruppe stehen und
$R^5$, $R^6$ unabhängig voneinander jeweils für H oder eine gegebenenfalls substituierte $C_1$-$C_{20}$-Alkylgruppe, eine gegebenenfalls substituierte $C_1$-$C_{20}$-Alkoxygruppe oder gemeinsam für eine gegebenenfalls substituierte $C_1$-$C_6$-Dioxyalky-lengruppe stehen.

6. Lösungen gemäß Anspruch 4 und 5, **dadurch gekennzeichnet, dass** n für eine ganze Zahl von 4 bis 100 steht.

7. Lösungen gemäß wenigstens einem der Ansprüche 4 bis 6, **dadurch gekennzeichnet, dass** n für eine ganze Zahl von 4 bis 10 steht.

8. Lösungen gemäß wenigstens einem der Ansprüche 4 bis 7, **dadurch gekennzeichnet, dass** $R^{4a}$ und $R^{4b}$ unabhängig voneinander jeweils für eine $C_1$-$C_{12}$-Alkylgruppe stehen.

**9.** Lösungen gemäß wenigstens einem der Ansprüche 4 bis 8, **dadurch gekennzeichnet, dass** $R^5$ und $R^6$ unabhängig voneinander jeweils für H oder eine $C_1$-$C_6$-Alkylgruppe stehen.

**10.** Lösungen gemäß wenigstens einem der Ansprüche 1 bis 9, **dadurch gekennzeichnet, dass** sie als Lösungsmittel halogenierte aromatische oder aliphatische Verbindungen, Ether- oder Ketogruppcn enthaltende aromatische oder aliphatische Verbindungen oder Mischungen aus zwei oder mehreren dieser Verbindungen enthalten.

**11.** Lösungen gemäß wenigstens einem der Ansprüche 1 bis 10, **dadurch gekennzeichnet, dass** sie als Lösungsmittel Chloroform, Toluol, Chlorbezol oder 1,2,4-Trichlorbenzol enthalten.

**12.** Verfahren zur Herstellung einer halbleitenden Schicht, **dadurch gekennzeichnet, dass** die Schicht aus einer Lösung gemäß mindestens einem der Ansprüche 1 bis 11 auf ein Substrat aufgetragen wird.

## Claims

**1.** Solutions comprising organic semiconducting compounds, comprising at least one solvent and, as a stabilizer, at least one basic compound, **characterized in that** the basic compound is a primary, secondary or tertiary amine, a basic, aromatic or aliphatic heterocyclic compound or a mixture of two or more of these compounds, or an alkali metal or alkaline earth metal hydroxide, an alkali metal or alkaline earth metal carbonate, an alkali metal or alkaline earth metal salt of a weak acid or a mixture of two or more of these compounds or a polymer comprising basic groups.

**2.** Solutions according to claim 1, **characterized in that** the basic compound is a primary, secondary or tertiary amine, a basic, aromatic or aliphatic heterocyclic compound or a mixture of two or more of these compounds and has a boiling point of at most 260°C.

**3.** Solutions according to claim 1 or 2, **characterized in that** the basic compound is an optionally substituted aromatic or an optionally substituted saturated or unsaturated aliphatic heterocyclic compound having 5 to 20 ring C atoms and 1 to 3 identical or different ring hetero atoms from the group of nitrogen, oxygen and sulphur,
or is a compound of the general formula (I)

$$H_xN(R^{1,2,3})_{3-x} \qquad (I)$$

wherein

x represents 0, 1 or 2,
$R^{1,2,3}$ represents one, two or three identical or different radicals $R^1$, $R^2$, $R^3$,
$R^1$ $R^2$, $R^3$ are identical or different and represent optionally substituted linear or branched $C_1$-$C_{20}$-alkyl, $C_1$-$C_{20}$-cycloalkyl or $C_1$-$C_{20}$-aryl.

**4.** Solutions according to at least one of claims 1 to 3, **characterized in that** the organic semiconducting compounds are compounds of the general formula (II)

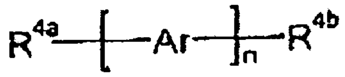 (II)

wherein

n represents an integer from 4 to 100,000,
$R^{4a}$, $R^{4b}$ independently of each other each represent H or a $C_1$-$C_{20}$-alkyl group optionally interrupted by one or more O or S atoms or silylene, phosphonoyl or phosphoryl groups and
Ar represents optionally substituted 1,4-phenylene, 2,7-fluorene or 2,5-thiophene, wherein Ar can be identical or different.

**5.** Solutions according to at least one of claims 1 to 4, **characterized in that** the organic semiconducting compounds

are compounds of the general formula (II-a)

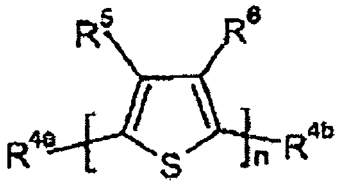

(II-a)

wherein

n represents an integer from 4 to 100,000,
$R^{4a}$, $R^{4b}$ independently of each other each represent H or a $C_1$-$C_{20}$-alkyl group optionally interrupted by one or more O or S atoms or silylene, phosphonoyl or phosphoryl groups and
$R^5$, $R^6$ independently of each other each represent H or an optionally substituted $C_1$-$C_{20}$-alkyl group, an optionally substituted $C_1$-$C_{20}$-alkoxy group or together represent an optionally substituted $C_1$-$C_6$-dioxyalkylene group.

6. Solutions according to claim 4 and 5, **characterized in that** n represents an integer from 4 to 100.

7. Solutions according to at least one of claims 4 to 6, **characterized in that** n represents an integer from 4 to 10.

8. Solutions according to at least one of claims 4 to 7, **characterized in that** $R^{4a}$ and $R^{4b}$ independently of each other each represent a $C_1$-$C_{12}$-alkyl group.

9. Solutions according to at least one of claims 4 to 8, **characterized in that** $R^5$ and $R^6$ independently of each other each represent H or a $C_1$-$C_6$-alkyl group.

10. Solutions according to at least one of claims 1 to 9, **characterized in that** they comprise as the solvent halogenated aromatic or aliphatic compounds, aromatic or aliphatic compounds containing ether or keto groups or mixtures of two or more of these compounds.

11. Solutions according to at least one of claims 1 to 10, **characterized in that** they comprise as the solvent chloroform, toluene, chlorobenzene or 1,2,4-trichlorobenzene.

12. Process for the production of a semiconducting layer, **characterized in that** the layer is applied to a substrate from a solution according to at least one of claims 1 to 11.

**Revendications**

1. Solutions comprenant des composés semi-conducteurs organiques, comprenant au moins un solvant et comme stabilisant au moins un composé basique, **caractérisées en ce que** le composé basique est une amine primaire, secondaire ou tertiaire, un composé hétérocyclique basique aromatique ou aliphatique ou un mélange de deux ou plus de ces composés, un hydroxyde alcalin ou alcalino-terreux, un carbonate alcalin ou alcalino-terreux, un sel alcalin ou alcalino-terreux d'un acide faible ou un mélange de deux ou plus de ces composés ou un polymère comprenant des groupes basiques.

2. Solutions selon la revendication 1, **caractérisées en ce que** le composé basique est une amine primaire, secondaire ou tertiaire, un composé hétérocyclique basique aromatique ou aliphatique ou un mélange de deux ou plus de ces composés, et a un point d'ébullition de 260°C maximum.

3. Solutions selon la revendication 1 ou 2, **caractérisées en ce que** le composé basique est un composé hétérocyclique aromatique éventuellement substitué ou hétérocyclique aliphatique saturé ou insaturé éventuellement substitué ayant de 5 à 20 atomes de C dans le cycle et 1 à 3 hétéroatomes identiques ou différents dans le cycle, choisis dans le groupe constitué par l'azote, l'oxygène et le soufre, ou un composé de formule générale (I),

$$H_xN(R^{1,2,3})_{3-x} \qquad (I)$$

dans laquelle

x représente 0, 1 ou 2,
$R^{1,2,3}$ représente un, deux ou trois radicaux identiques ou différents $R^1$, $R^2$, $R^3$,
$R^1$, $R^2$, $R^3$ sont identiques ou différents et représentent un groupe alkyle en $C_1$-$C_{20}$, cycloalkyle en $C_1$-$C_{20}$ ou aryle en $C_1$-$C_{20}$, linéaire ou ramifié, éventuellement substitué.

**4.** Solutions selon au moins l'une des revendications 1 à 3, **caractérisées en ce que** les composés semi-conducteurs organiques sont des composés de formule générale (II),

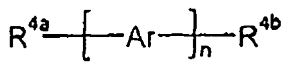
(II)

dans laquelle

n représente un nombre entier de 4 à 100 000,
$R^{4a}$, $R^{4b}$ représentent, indépendamment les uns des autres, respectivement H ou un groupe alkyle en $C_1$-$C_{20}$ interrompu éventuellement par un ou plusieurs atomes de O ou de S, des groupes silylènes, phosphonoyles ou phosphoryles et
Ar représente un groupe 1,4-phénylène, 2,7-fluorène ou 2,5-thiophène éventuellement substitué, où Ar peut être identique ou différent.

**5.** Solutions selon au moins une des revendications 1 à 4, **caractérisées en ce que** les composés semi-conducteurs organiques sont des composés de formule générale (II-a),

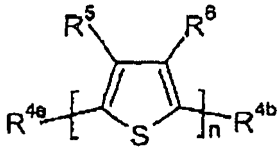
(II-a)

dans laquelle

n représente un nombre entier de 4 à 100 000,
$R^{4a}$, $R^{4b}$ représentent, indépendamment les uns des autres, respectivement H ou un groupe alkyle en $C_1$-$C_{20}$ interrompu éventuellement par un ou plusieurs atomes de O ou de S, des groupes silylènes, phosphonoyles ou phosphoryles et
$R^5$, $R^6$ représentent, indépendamment les uns des autres, respectivement H ou un groupe alkyle en $C_1$-$C_{20}$ éventuellement substitué, un groupe alkcoxy en $C_1$-$C_{20}$ éventuellement substitué, ou ensemble un groupe dioxyalkylène en $C_1$-$C_6$ éventuellement substitué.

**6.** Solutions selon la revendication 4 et 5, **caractérisées en ce que** n représente un nombre entier de 4 à 100.

**7.** Solutions selon au moins l'une des revendications 4 à 6, **caractérisées en ce que** n représente un nombre entier de 4 à 10.

**8.** Solutions selon au moins l'une des revendications 4 à 7, **caractérisées en ce que** $R^{4a}$ et $R^{4b}$ représentent, indépendamment les uns des autres, respectivement un groupe alkyle en $C_1$-$C_{12}$.

9. Solutions selon au moins l'une des revendications 4 à 8, **caractérisées en ce que** $R^5$ et $R^6$ représentent, indépendamment les uns des autres, respectivement H ou un groupe alkyle en $C_1$-$C_6$.

10. Solutions selon au moins l'une des revendications 1 à 9, **caractérisées en ce qu'**elles comprennent comme solvant des composés aromatiques ou aliphatiques halogénés, des composés aromatiques ou aliphatiques comprenant des groupes éthers ou cétones ou des mélanges de deux ou plus de ces composés.

11. Solutions selon au moins l'une des revendications 1 à 10, **caractérisées en ce qu'**elles comprennent comme solvant du chloroforme, du toluène, du chlorobenzène ou du 1,2,4-trichlorobenzène.

12. Procédé de fabrication d'une couche semi-conductrice, **caractérisée en ce que** la couche d'une solution selon au moins l'une des revendications 1 à 11 est déposée sur un substrat.

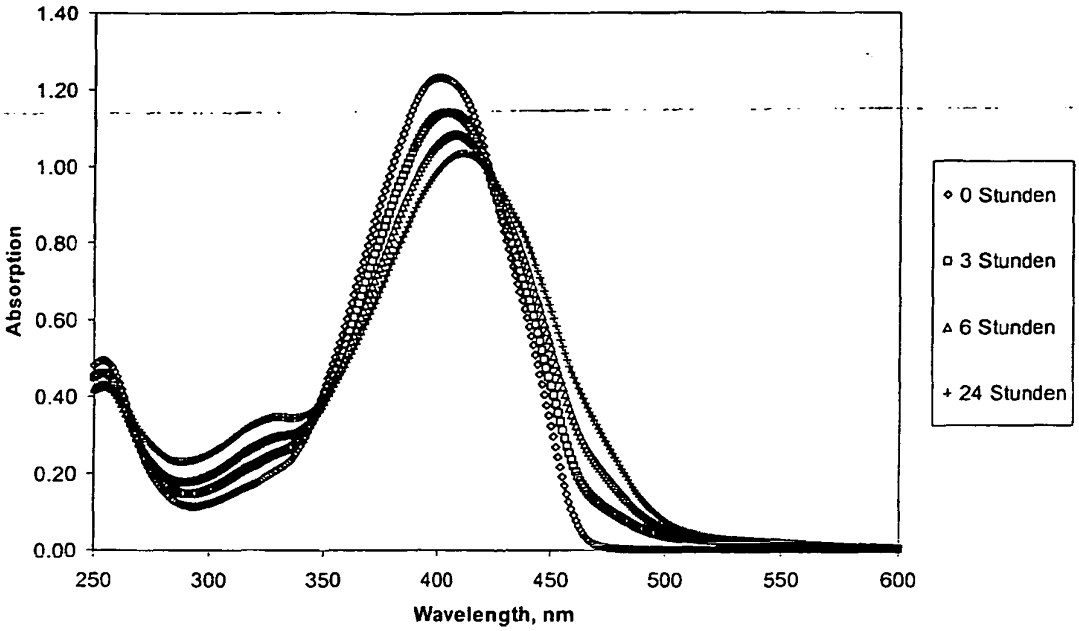
Absorption
1.40
1.20
1.00
0.80
0.60
0.40
0.20
0.00
250
300
350
400
450
500
550
600
Wavelength, nm
0 Stunden
3 Stunden
6 Stunden
24 Stunden

Fig. 1

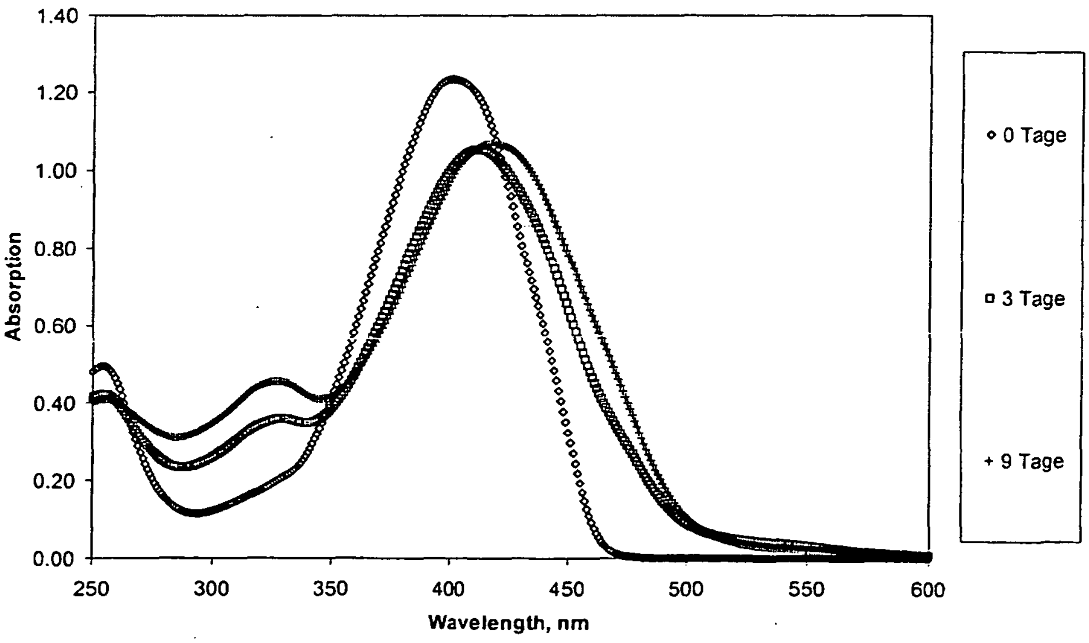
Absorption
1.40
1.20
1.00
0.80
0.60
0.40
0.20
0.00
250
300
350
400
450
500
550
600
Wavelength, nm
0 Tage
3 Tage
9 Tage

Fig. 2

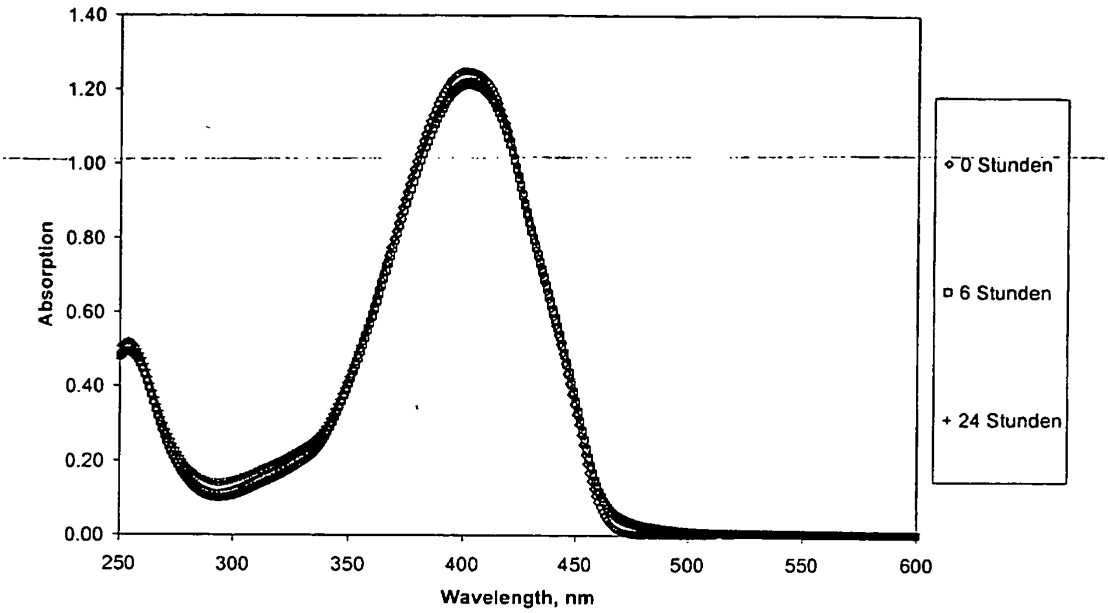
1.40
1.20
1.00
0.80
0.60
0.40
0.20
0.00
Absorption
250
300
350
400
450
500
550
600
Wavelength, nm
0 Stunden
6 Stunden
24 Stunden

Fig. 3

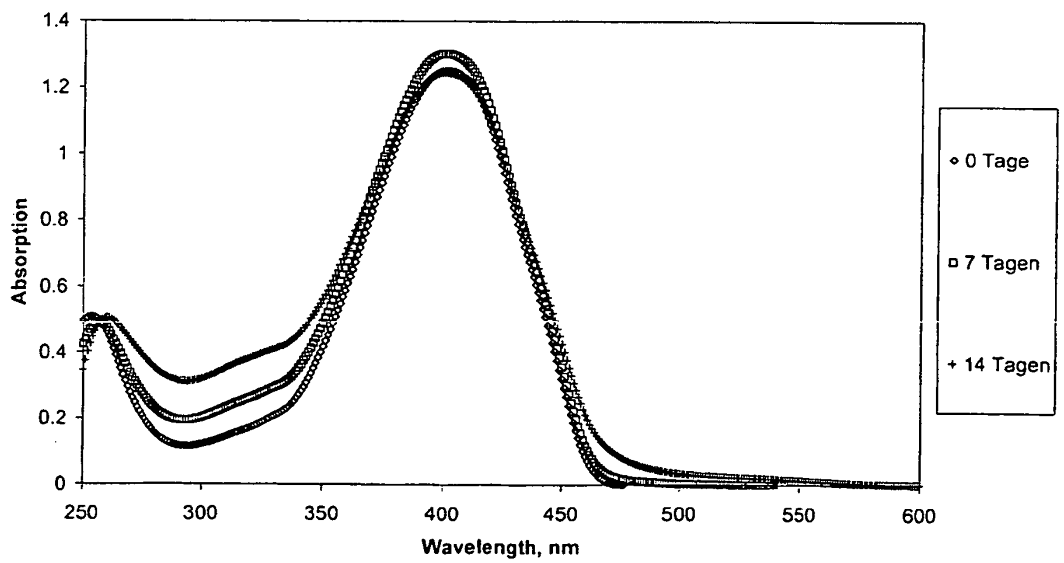
1.4
1.2
1
0.8
0.6
0.4
0.2
0
Absorption
250
300
350
400
450
500
550
600
Wavelength, nm
0 Tage
7 Tagen
14 Tagen

Fig. 4

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- JP 02250881 A
- EP 1028136 A2
- US 5546889 A
- DE 10248876